# EUROPÄISCHE PATENTSCHRIFT

(11) **EP 3 338 302 B1**
(45) Veröffentlichungstag und Bekanntmachung des Hinweises auf die Patenterteilung: **01.05.2019**
(21) Anmeldenummer: 16750791.2
(22) Anmeldetag: 08.08.2016
(51) Int. Cl.: H01L 23/373, H01L 23/14

(54) **SCHALTUNGSTRÄGER, LEISTUNGSELEKTRONIKANORDNUNG MIT EINEM SCHALTUNGSTRÄGER**
CIRCUIT CARRIER, POWER ELECTRONICS ASSEMBLY HAVING A CIRCUIT CARRIER
CARTE DE CIRCUITS IMPRIMÉS ET ENSEMBLE ÉLECTRONIQUE DE PUISSANCE ÉQUIPÉ D'UNE CARTE DE CIRCUITS IMPRIMÉS

(30) Priorität: 21.08.2015 DE 102015216047
(43) Veröffentlichungstag der Anmeldung: 27.06.2018
(73) Patentinhaber: Continental Automotive GmbH, 30165 Hannover (DE)
(72) Erfinder: MATTMANN, Erich, 55262 Heidesheim (DE); BERGMANN, Sabine, 65795 Hattersheim am Main (DE); BREY, Roland, 93458 Eschlkam (DE); RITTSTIEG, Soeren, 93073 Neutraubling (DE)
(86) Internationale Anmeldenummer: PCT/EP2016/068859
(87) Internationale Veröffentlichungsnummer: WO 2017/032581

(56) Entgegenhaltungen:
- WO-A1-2016/016140
- JP-A- 2009 038 162
- JP-A- 2012 222 327

## Beschreibung

### Technisches Gebiet:

Die Erfindung betrifft einen Schaltungsträger zum Halten mindestens eines elektrischen Leistungsbauelements und eine Leistungselektronikanordnung mit einem genannten Schaltungsträger.

### Stand der Technik:

Aus der Druckschrift JP 2009 038162 A ist ein Schaltungsträger zum Halten von elektrischen Leistungsbauelementen bekannt, der einen Kühlkörper zum Halten und zum Kühlen der Leistungsbauelemente aufweist. Der Kühlkörper weist eine Oberfläche auf, auf der eine Kupferschicht ausgebildet ist.

Aus der Druckschrift JP 2012 222327 A ist eine Halbleitervorrichtung mit einer leitfähigen Materialschicht bekannt, wobei die Materialschicht mit einer Wärmesenke thermisch verbunden ist.

Leistungsbauelemente werden aufgrund ihrer hohen Verlustleistungen und damit der gebundenen Wärmeentwicklung in der Regel auf keramischen Schaltungsträgern (DCB) angeordnet, die eine gute Wärmeleitfähigkeit aufweisen. Auf den keramischen Schaltungsträgern werden elektrische Leiterbahnen ausgebildet, über die die Leistungsbauelemente miteinander und mit externen elektrischen Komponenten elektrisch verbunden sind. Die Wärmeabführung über die keramischen Schaltungsträger ist aber nicht ausreichend effizient, sodass ein Schutz der Leistungsbauelemente vor einer Überhitzung nicht ausreichend gesichert ist. Die keramischen Schaltungsträger sind teuer. Zudem ist in manchen Anwendungsbereichen, wie z. B. im Automobilbereich, insb. im Bereich Hybridelektro-/Elektrofahrzeuge, eine bessere Wärmeabführung wünschenswert.

Damit besteht die Aufgabe der vorliegenden Erfindung darin, eine Möglichkeit zur effizienten und kostengünstigen Wärmeabführung für die Leistungsbauelemente bereitzustellen.

### Beschreibung der Erfindung:

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird ein Schaltungsträger zum Halten mindestens eines Leistungsbauelements bereitgestellt.

Der Schaltungsträger umfasst einen Kühlkörper mit einer Oberfläche, der zum Halten und zum Kühlen des Leistungsbauelements ausgeführt ist. Der Schaltungsträger umfasst ferner eine Kupferschicht, die aus Kupfer oder einer Kupferlegierung besteht und ausgeführt ist, den Kühlkörper mit mindestens einer Kupferplatte mechanisch zu verbinden. Die Kupferschicht ist dabei auf der Oberfläche des Kühlkörpers kaltgasgespritzt oder gesintert. Der Schaltungsträger umfasst ferner mindestens eine Kupferplatte, die ebenfalls aus Kupfer oder einer Kupferlegierung besteht und ausgeführt ist, das Leistungsbauelement mit der Kupferschicht mechanisch und elektrisch leitend zu verbinden. Dabei ist die Kupferplatte unmittelbar auf einer von dem Kühlkörper abgewandten Oberfläche der Kupferschicht angeordnet und mit der Kupferschicht flächig, mechanisch und elektrisch leitend verbunden.

Ein Leistungsbauelement kann hierbei ein passiver oder ein aktiver elektrisches bzw. elektronisches Bauelement sein, wie z. B. ein Leistungskondensator oder ein Leistungshalbleiterschalter. Ein Leistungsbauelement kann auch ein elektrischer Leiter sein, der zum Übertragen von Strömen mit einer Stromstärke von über 100 Ampere vorgesehen ist.

Der Kühlkörper dient als Wärmesenke und nimmt die Abwärme auf, die während des Betriebs beim Leistungsbauelement entsteht. Zudem dient der Kühlkörper als Träger des Leistungsbauelements bzw. der Leiterbahn zu dem Leistungsbauelement und gibt mechanischen Halt für das Leistungsbauelements bzw. die Leiterbahn. Damit ersetzt der Kühlkörper einen teuren keramischen Schaltungsträger, der sonst zum Halten des Leistungsbauelements und der Leiterbahn erforderlich wäre. Dadurch werden Kosten für Schaltungsträger reduziert.

Die Kupferschicht dient als Leiterbahn zur Übertragung von elektrischen Strömen von/zu dem Leistungsbauelement. Hierzu weist die Kupferschicht einen entsprechend einem vorgegebenen Schaltungslayout der Leistungselektronikanordnung strukturierten Verlauf auf. Zudem dient die Kupferschicht als effizienter Wärmeüberträger zum Weiterleiten der Abwärme von dem Leistungsbauelement zu dem Kühlkörper. Die Kupferschicht ist in einem Kaltgasspritz- oder Sintervorgang auf der Oberfläche des Kühlkörpers geformt.

Eine "Schicht" bedeutet in dieser Anmeldung einen flächig (insb. eben) ausgedehnten Belag aus einem entsprechenden Material, der eine Dicke von maximal 1 Millimeter, insbesondere maximal 0,5 Millimeter, speziell maximal 0,2 Millimeter, und bspw. maximal 0,1 Millimeter aufweist. Damit ist eine Kupferschicht ein flächig ausgedehnter Belag aus Kupfer oder einer Kupferlegierung mit einer Schichtdicke von kleiner als 1 Millimeter, der durch Kaltgasspritzen oder durch Sintern hergestellt ist.

Die Kupferplatte ist eine dünne Platte aus Kupfer oder einer Kupferlegierung, die bspw. aus einem dünnen Blech aus Kupfer oder einer Kupferlegierung ausgestanzt oder in sonstiger Weise herausgeschnitten ist. Eine Kupferplatte ist insb. keine Kupferschicht, welche in einem Kaltgasspritz- oder Sinterverfahren oder sonstigen ähnlichen Beschichtungsverfahren hergestellt bzw. auf der genannten Oberfläche des Kühlkörpers geformt ist. Die Kupferplatte ermöglicht sowohl eine Lötverbindung als auch eine Schweißverbindung. Als Schweißpartner kann die Kupferplatte ohne weiteres bspw. mit einem elektrischen Leiter geschweißt, insb. lasergeschweißt oder mit Sonotroden geschweißt werden.

Eine "flächige (mechanische bzw. elektrische) Verbindung" bedeutet eine (mechanische bzw. elektrische) Verbindung über eine ausgedehnte Kontaktfläche, die sich im Wesentlichen über die gesamte elektrische Kontaktfläche eines elektrischen Anschlusses des elektrisch zu kontaktierenden Leistungsbauelements erstreckt und somit die größtmögliche Wärmeübergangsfläche von dem Leistungsbauelement über die Kupferplatte und die Kupferschicht zu dem Kühlkörper bietet. Damit ermöglicht die "flächige Verbindung" eine effiziente Wärmeabführung von dem Leistungsbauelement zu dem Kühlkörper.

Eine "unmittelbare Anordnung" bedeutet eine Anordnung des Leistungsbauelements auf der Kupferplatte, die lediglich über eine direkte Verbindungsschicht und ohne weitere Zwischenschichten oder sonstigen Zwischenelemente ausgebildet ist, die nicht primär zur Herstellung einer direkten mechanischen und körperlichen Verbindung des Leistungsbauelements mit der Kupferplatte ausgeführt sind. Damit ist das Leistungsbauelement lediglich über eine Verbindungsschicht unmittelbar mit der Kupferplatte flächig, mechanisch und elektrisch leitend verbunden.

Die Kupferschicht und die Kupferpatte aus Kupfer oder einer Kupferlegierung weisen sehr hohe Wärmeleitfähigkeiten auf und ermöglichen somit eine effiziente Wärmeabführung für das Leistungsbauelement.

Darüber hinaus ermöglicht die Kupferschicht eine kostengünstige mechanische Verbindung der Kupferplatte bzw. des Leistungsbauelements mit dem Kühlkörper. Dadurch, dass die Kupferschicht auf der Oberfläche des Kühlkörpers kaltgasgespritzt bzw. gesintert ist, weist die Kupferschicht eine hohe Duktilität auf und kann unterschiedliche Wärmeausdehnungen zwischen dem Kühlkörper und der Kupferplatte bzw. dem Leistungsbauelement ausgleichen. Damit stellt die Kupferschicht sicher, dass die Kupferplatte und somit auch das Leistungsbauelement trotz der mechanischen Spannungen infolge der unterschiedlichen Wärmeausdehnungen auf dem Kühlkörper sicher angehaftet bleiben.

Damit ist eine effiziente und kostengünstige Wärmeabführung für die Leistungsbauelemente bereitgestellt.

Vorzugsweise weist die Kupferschicht eine Schichtdicke auf, die mindestens 45 Mikrometer, insbesondere mindestens 50 Mikrometer, speziell mindestens 100 Mikrometer, beträgt.

Die Kupferplatte ist vorzugsweise auf der Oberfläche der Kupferschicht verlötet und dient als eine Verbindungsfläche zum Verbinden der Kupferschicht mit mindestens einem Leistungsbauelement. Dadurch, dass die Kupferschicht und die Kupferplatte aus einem gleichen oder ähnlichen kupferbasierten Material bestehen, können diese miteinander in einfacher Weise verlötet werden. Die Verbindungsfläche der Kupferplatte ermöglicht eine stabile elektrische und mechanische Verbindung für die Hochstromanschlüsse der Leistungsbauelemente.

Die Kupferplatte weist vorzugsweise eine Materialdicke auf, die mindestens 0, 9 Millimeter, insbesondere mindestens 1 Millimeter, speziell mindestens 2 Millimeter, beträgt.

Vorzugsweise umfasst der Schaltungsträger ferner eine Isolationsschicht, die zwischen der Oberfläche des Kühlkörpers und der Kupferschicht angeordnet ist und die Kupferschicht mit dem Kühlkörper mechanisch verbindet und zugleich elektrisch isoliert. Dabei ist die Isolationsschicht aus einem elektrisch isolierenden und thermisch leitenden Material, insb. einem Keramik, ausgebildet.

Vorzugsweise ist die Isolationsschicht auf der Oberfläche des Kühlkörpers kaltgasgespritzt oder gesintert.

Die Isolationsschicht weist eine Schichtdicke auf, die ausreichend dick ist, um die Kupferschicht von dem (ggfs. elektrisch leitfähigen) Kühlkörper wirksam elektrisch zu isolieren, und genügend dünn ist, um die Abwärme von dem Leistungsbauelement zu dem Kühlkörper effizient übertragen zu können.

Gemäß einem weiteren Aspekt der Erfindung wird eine Leistungselektronikanordnung bereitgestellt. Die Leistungselektronikanordnung umfasst mindestens ein Leistungsbauelement und mindestens einen zuvor beschriebenen Schaltungsträger. Dabei ist das Leistungsbauelement auf einer von dem Kühlkörper abgewandten Oberfläche der Kupferplatte des Schaltungsträgers angeordnet und mit der Kupferplatte flächig, mechanisch und elektrisch leitend verbunden.

Vorteilhafte Ausgestaltungen des oben beschriebenen Schaltungsträgers sind, soweit im Übrigen auf die oben genannte Leistungselektronikanordnung übertragbar, auch als vorteilhafte Ausgestaltungen der Leistungselektronikanordnung anzusehen.

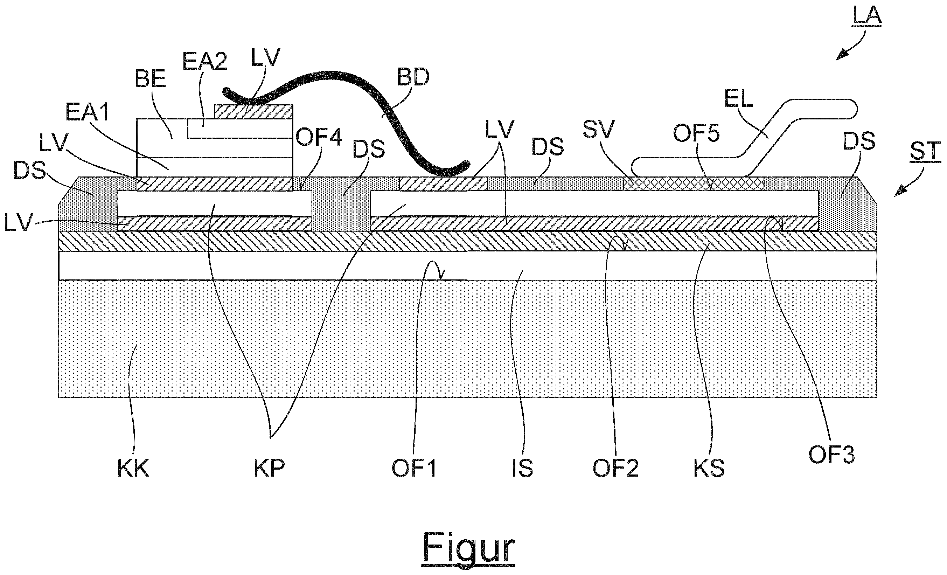

### Beschreibung der Zeichnung:

Im Folgenden wird eine beispielhafte Ausführungsform der Erfindung bezugnehmend auf die beiliegende Zeichnung näher erläutert. Dabei zeigt die einzige Figur in einer schematischen Querschnittdarstellung eine Leistungselektronikanordnung LA gemäß einer Ausführungsform der Erfindung.

Die in der Figur dargestellte Leistungselektronikanordnung LA ist beispielsweise ein Teil eines Inverters bzw. einer Endstufe des Inverters für einen Elektroantrieb eines Hybridelektro-/Elektrofahrzeugs.

Die Leistungselektronikanordnung LA umfasst einen Schaltungsträger ST und einen auf den Schaltungsträger ST montierten Leistungshalbleiterschalter (Leistungsbauelement) BE.

Der Schaltungsträger ST umfasst einen Kühlkörper KK, der aus Aluminium besteht und in einem Druckgießverfahren hergestellt ist. Der Kühlkörper KK weist eine ebene Oberfläche OF1 auf, auf der eine Isolierschicht IS angeordnet ist. Dabei besteht die Isolierschicht IS aus einer elektrisch isolierenden, thermisch leitenden Keramik und ist in einem Kaltgasspritzvorgang auf die Oberfläche OF1 des Kühlkörpers KK beschichtet. Die Isolierschicht IS isoliert den Leistungshalbleiterschalter BE von dem Kühlkörper KK elektrisch und zugleich überträgt Abwärme von dem Leistungshalbleiterschalter BE zu dem Kühlkörper KK.

Auf einer von dem Kühlkörper KK abgewandten Oberfläche OF2 der Isolierschicht IS weist der Schaltungsträger ST eine Kupferschicht KS auf, die aus einer Kupferlegierung besteht und in einem weiteren Kaltgasspritzvorgang auf die Oberfläche OF2 beschichtet ist. Die Kupferschicht KS dient zur mechanischen und elektrischen Verbindung von nachfolgend zu beschreibenden Kupferplatten KP mit dem Kühlkörper KK.

Auf einer von dem Kühlkörper KK abgewandten Oberfläche OF3 der Kupferschicht KS weist der Schaltungsträger ST zwei Kupferplatten KP auf, die mit der Kupferschicht KS flächig, mechanisch und elektrisch leitend verlötet sind.

Auf einer von dem Kühlkörper KK abgewandten Oberfläche OF4 einer der beiden Kupferplatten KP ist der Leistungshalbleiterschalter BE angeordnet. Der Leistungshalbleiterschalter BE weist auf einer Oberfläche einen flächig ausgebildeten elektrischen Anschluss EA1 auf, der über eine Lötverbindung LV mit der Kupferplatte KP flächig, mechanisch und elektrisch leitend verbunden bspw. gelötet ist.

Auf einer ebenfalls von dem Kühlkörper KK abgewandten Oberfläche OF5 der anderen Kupferplatte KP ist ein Bonddraht BD angeordnet, das über eine Lötverbindung LV mit der Kupferplatte KP mechanisch und elektrisch leitend verbunden ist. Der Bonddraht BD ist ferner mit einem weiteren elektrischen Anschluss EA2 des Leistungshalbleiterschalters BE mechanisch und elektrisch leitend verlötet.

Auf der Oberfläche OF5 der weiteren Kupferplatte KP ist ferner ein elektrischer Leiter EL bzw. dessen Kontaktanschluss angeordnet und über eine Schweißverbindung SV (bspw. mit Sonotroden geschweißt) mit der Kupferplatte KP flächig, mechanisch und elektrisch leitend verbunden ist.

Auf den Oberflächen OF3, OF4, OF5 der Kupferschicht KS und der beiden Kupferplatten KP ist ferner eine Dichtschicht DS angeordnet, welche freiliegende, nicht mit jeweiligen darüber liegenden Schichten beziehungsweise Schaltungskomponenten abgedeckten Bereiche der Kupferschicht KS und der beiden Kupferplatten KP mediendicht abdecken und diese vor Umwelteinflüssen, wie z. B. der Feuchtigkeit, schützen. Die Dichtschicht DS ist bspw. aus einer elektrisch isolierenden und thermisch leitenden Moldmasse ausgebildet, die auf die Oberflächen OF3, OF4, OF5 umgossen ist.

## Patentansprüche

1. Schaltungsträger (ST) zum Halten mindestens eines elektrischen Leistungsbauelements (BE), umfassend:
- einen Kühlkörper (KK) zum Halten und zum Kühlen des Leistungsbauelements (BE), der eine Oberfläche (OF1) aufweist;
- eine Kupferschicht (KS), wobei die Kupferschicht (KS) aus Kupfer oder einer Kupferlegierung besteht,
**dadurch gekennzeichnet, dass**
- der Schaltungsträger (ST) ferner mindestens eine Kupferplatte (KP) zur mechanischen und elektrischen Verbindung des Leistungsbauelements (BE) mit der Kupferschicht (KS) aufweist, wobei die Kupferplatte (KP) aus Kupfer oder einer Kupferlegierung besteht und unmittelbar auf einer von dem Kühlkörper (KK) abgewandten Oberfläche (OF3) der Kupferschicht (KS) angeordnet ist und mit der Kupferschicht (KS) flächig, mechanisch und elektrisch leitend verbunden ist;
- wobei die Kupferschicht (KS) zur mechanischen Verbindung des Kühlkörpers (KK) mit der mindestens einen Kupferplatte (KP) ausgeführt ist und auf der Oberfläche (OF1) des Kühlkörpers (KK) kaltgasgespritzt oder gesintert ist.

2. Schaltungsträger (ST) nach Anspruch 1, wobei die Kupferschicht (KS) eine Dicke von mindestens 45 Mikrometer, insb. mindestens 50 Mikrometer, speziell mindestens 100 Mikrometer, aufweist.

3. Schaltungsträger (ST) nach Anspruch 1 oder 2, wobei die Kupferplatte (KP) auf der Oberfläche (OF3) der Kupferschicht (KS) gelötet ist und zur elektrischen und mechanischen Verbindung der Kupferschicht mit mindestens einem Leistungsbauelement (BE) dient.

4. Schaltungsträger (ST) nach einem der vorangehenden Ansprüche, wobei die Kupferplatte (KP) eine Dicke von mindestens 0,9 Millimeter, insb. mindestens 1 Millimeter, speziell mindestens 2 Millimeter, aufweist.

5. Schaltungsträger (ST) nach einem der vorangehenden Ansprüche, ferner umfassend eine Isolierschicht (IS), die zwischen der Oberfläche (OF1) des Kühlkörpers (KK) und der Kupferschicht (KS) angeordnet ist und den Kühlkörper (KK) mit der Kupferschicht (KS) mechanisch verbindet und elektrisch isoliert.

6. Schaltungsträger (ST) nach Anspruch 5, wobei die Isolierschicht (IS) auf der Oberfläche (OF1) des Kühlkörpers (KK) kaltgasgespritzt oder gesintert ist.

7. Leistungselektronikanordnung (LA), umfassend:
- mindestens ein elektrisches Leistungsbauelement (BE);
- mindestens einen Schaltungsträger (ST) nach einem der vorangehenden Ansprüche, wobei das Leistungsbauelement (BE) auf einer von dem Kühlkörper (KK) abgewandten Oberfläche (OF4) der Kupferplatte (KP) angeordnet ist und mit der Kupferplatte (KP) flächig, mechanisch und elektrisch leitend verbunden ist.

## Claims

1. Circuit carrier (ST) for holding at least one electrical power component (BE), comprising:
- a cooling body (KK) for holding and for cooling the power component (BE), said cooling body having a surface (OF1);
- a copper layer (KS), wherein the copper layer (KS) consists of copper or a copper alloy,
**characterized in that**
- the circuit carrier (ST) furthermore comprises at least one copper plate (KP) for mechanically and electrically connecting the power component (BE) to the copper layer (KS), wherein the copper plate (KP) consists of copper or a copper alloy and is arranged directly on a surface (OF3) of the copper layer (KS) facing away from the cooling body (KK) and is areally, mechanically and electrically conductively connected to the copper layer (KS);
- wherein the copper layer (KS) is embodied for mechanically connecting the cooling body (KK) to the at least one copper plate (KP) and is cold-gas-sprayed or sintered on the surface (OF1) of the cooling body (KK).

2. Circuit carrier (ST) according to Claim 1, wherein the copper layer (KS) has a thickness of at least 45 micrometers, in particular at least 50 micrometers, especially at least 100 micrometers.

3. Circuit carrier (ST) according to Claim 1 or 2, wherein the copper plate (KP) is soldered on the surface (OF3) of the copper layer (KS) and serves for electrically and mechanically connecting the copper layer to at least one power component (BE).

4. Circuit carrier (ST) according to any of the preceding claims, wherein the copper plate (KP) has a thickness of at least 0.9 millimeter, in particular at least 1 millimeter, especially at least 2 millimeters.

5. Circuit carrier (ST) according to any of the preceding claims, furthermore comprising an insulation layer (IS) which is arranged between the surface (OF1) of the cooling body (KK) and the copper layer (KS) and mechanically connects the cooling body (KK) to, and electrically insulates it from, the copper layer (KS).

6. Circuit carrier (ST) according to Claim 5, wherein the insulation layer (IS) is cold-gas-sprayed or sintered on the surface (OF1) of the cooling body (KK).

7. Power electronics arrangement (LA), comprising:
- at least one electrical power component (BE);
- at least one circuit carrier (ST) according to any of the preceding claims, wherein the power component (BE) is arranged on a surface (OF4) of the copper plate (KP) facing away from the cooling body (KK) and is areally, mechanically and electrically conductively connected to the copper plate (KP).

## Revendications

1. Porte-circuit (ST) destiné à porter au moins un composant électrique de puissance (BE) et comportant :
- un corps de refroidissement (KK) qui porte et refroidit le composant électrique de puissance (BE) qui présente une surface (OF1),
- une couche de cuivre (KS), la couche de cuivre (KS) étant constituée de cuivre ou d'un alliage de cuivre,
**caractérisé en ce que**
- le porte-circuit (ST) présente en outre au moins une plaque de cuivre (KP) qui relie mécaniquement et électriquement le composant de puissance (BE) à la couche de cuivre (KS), la plaque de cuivre (KP) étant constituée de cuivre ou d'un alliage de cuivre, étant disposée directement sur une surface (OF3), non tournée vers le corps de refroidissement (KK), de la couche de cuivre (KS) et étant reliée à plat, mécaniquement et de manière électriquement conductrice à la couche de cuivre (KS),
- la couche de cuivre (KS) étant configurée avec au moins une plaque de cuivre (KP) pour assurer la liaison mécanique du corps de refroidissement (KK) avec la ou les plaques de cuivre (KP) et étant formée par pulvérisation à froid en phase gazeuse ou par frittage sur la surface (OF1) du corps de refroidissement (KK).

2. Porte-circuit (ST) selon la revendication 1, dans lequel la couche de cuivre (KS) a une épaisseur d'au moins 45 micromètres, en particulier d'au moins 50 micromètres et notamment d'au moins 100 micromètres.

3. Porte-circuit (ST) selon les revendications 1 ou 2, dans lequel la plaque de cuivre (KP) est brasée sur la surface (OF3) de la couche de cuivre (KS) et sert à assurer la liaison électrique et mécanique de la couche de cuivre avec au moins un composant de puissance (BE).

4. Porte-circuit (ST) selon l'une des revendications précédentes, dans lequel la plaque de cuivre (KP) a une épaisseur d'au moins 0,9 millimètre, en particulier d'au moins 1 millimètre et notamment d'au moins 2 millimètres.

5. Porte-circuit (ST) selon l'une des revendications précédentes, comportant en outre une couche isolante (IS) disposée entre la surface (OF1) du corps de refroidissement (KK) et la couche de cuivre (KS), reliant mécaniquement le corps de refroidissement (KK) à la couche de cuivre (KS) et l'isolant électriquement de cette dernière.

6. Porte-circuit (ST) selon la revendication 5, dans lequel la couche isolante (IS) formée par pulvérisation à froid en phase gazeuse ou par frittage sur la surface (OF1) du corps de refroidissement (KK).

7. Circuit électronique de puissance (LA) comprenant
- au moins un composant électrique de puissance (BE) et
- au moins un porte-circuit (ST) selon l'une des revendications précédentes, le composant de puissance (BE) étant disposé sur une surface (OF4), non tournée vers le corps de refroidissement (KK), de la plaque de cuivre (KP) et étant relié à plat, mécaniquement et de manière électriquement conductrice à la plaque de cuivre (KP).
